# EUROPEAN PATENT APPLICATION

(11) **EP 1 149 864 A1**
(43) Date of publication of application: **31.10.2001**
(21) Application number: 00830320.8
(22) Date of filing: 28.04.2000
(51) Int. Cl.: C08K 3/36, C08L 63/00, H01L 23/29

(54) **Polymeric composition for packaging a semiconductor electronic device and packaging obtained therefrom**

(71) Applicant: STMicroelectronics S.r.l., 20041 Agrate Brianza (Milano) (IT); Toshiba Chemical Kawaguchi Works, Kawaguchi 332 (JP)
(72) Inventor: Zafarana, Roberto, 96100 Siracusa (IT); Scandurra, Antonino, 95125 Catania (IT); Pignataro, Salvatore, 95021 Aci Castello (Catania) (IT); Tenya, Yuichi, Kawaguchi, Saitama 333 (JP); Yoshizumi, Akira Kirigaoka Green Town 9-204, Yokohama, Kanagawa 226-0016 (JP)
(74) Representative: Botti, Mario

(57) **Abstract**

The invention relates to a polymeric composition for packaging a semiconductor electronic device comprising:
a) at least one epoxy resin,
b) at least one curing agent, in an amount comprised between 30 and 110 parts by weight per 100 parts by weight of epoxy resin,
c) at least one silica-based reinforcing filler, in an amount comprised between 300 and 2300 parts by weight per 100 parts of epoxy resin,
d) at least one control agent for the rheology of the polymeric composition, substantially free from polar groups, in an amount comprised between 0.1 and 50 parts by weight per 100 parts by weight of epoxy resin.

The invention also relates to a packaging of plastic material for microelectronic applications, which can be obtained starting from the aforesaid polymeric composition, and to a semiconductor electronic device comprising said packaging.

## Description

### Field of invention

The present invention relates, according to a first aspect thereof, to a polymeric composition for packaging a semiconductor electronic device.

The present invention also relates to a packaging of plastic material for microelectronic applications, which can be obtained starting from the aforesaid polymeric composition, and to a semiconductor electronic device comprising said packaging.

### Known art

As is known, in the field of microelectronic applications, it is very common to encapsulate semiconductor electronic devices, such as, for instance, power MOS (metal oxide semiconductor) devices, within packages of plastic material.

Power MOS electronic devices comprise a plurality of layers having different chemical structure (dissipating element, supporting frame, die of semiconductor material, packaging of plastic material), whose compatibility determines the performances and reliability of the device itself.

The reliability of a power device is determined by a number of tests. In particular, one of them, the so-called High Temperature Reverse Bias (HTRB), allows to estimate the reliability by submitting the device to high temperatures and simultaneously to reverse bias. The behaviour of the device in this test depends on the physical-chemical conditions of the die of semiconductor material of the circuit and the interactions with the packaging material.

Usually, such packaging of plastic material is obtained hardening a polymeric composition comprising a thermosetting resin and various additives, such as for instance reinforcing fillers based on fused or crystalline silica and at least one control agent for the rheology of the polymeric composition, based generally on siloxanes.

The thermosetting resin usually comprises an epoxy resin, generally obtained from an epoxy pre-cured with phenolic resin or an epoxy pre-cured with anhydride.

At present, in order to obtain a semiconductor electronic field has suggested to operate on the bulk characteristics of the packaging of plastic material of the device; so, for instance, it was suggested to reduce the content of ions, among which Na⁺ and Br⁻ ions coming from raw materials, and to have a high volume resistivity, preferably higher than 1×10¹²Ωcm. However, the reliability value obtained by submitting the semiconductor electronic devices of the known art to the HTRB test is inadequate compared to the always increasing reliability level required from said devices, in particular from power devices.

### Summary of the invention

The technical problem underlying the present invention is that of providing a polymeric composition for packaging a semiconductor electronic device that allows to improve the reliability of the semiconductor circuit over the devices of the known art.

The Applicants have sensed that in order to solve this problem it does not suffice to operate on the bulk characteristics of the packaging of the die of semiconductor material so as to have a low ionic content and a high volume resistivity, but it is necessary to reduce as much as possible the polarity of the packaging of plastic material layer at the interface with the die itself.

The Applicants have in fact found that the polarity characteristics at the interface between adjoining layers significantly affect the mechanical and electrical performances of the device.

According to a first aspect of the invention, therefore, the aforesaid technical problem is solved by a polymeric composition comprising:
a) at least one epoxy resin,
b) at least one curing agent, in an amount comprised between 30 and 110 parts by weight per 100 parts by weight of epoxy resin,
c) at least one silica-based reinforcing filler, in an amount comprised between 300 and 2300 parts by weight per 100 parts by weight of epoxy resin,
d) at least one control agent for the rheology of the polymeric composition, substantially free from polar groups, in an amount comprised between 0.1 and 50 parts by weight per 100 parts by weight of epoxy resin.

From the tests carried out by the Applicants, the electrical behaviour of the interface package of plastic material-die of semiconductor material was found to be substantially correlatable to the quantity of polar groups existing at the interface. In particular, it was found that a reduction in the quantity of polar groups at the interface, in particular those coming from the control agent for the rheology allows to markedly improve the reliability of the semiconductor device.

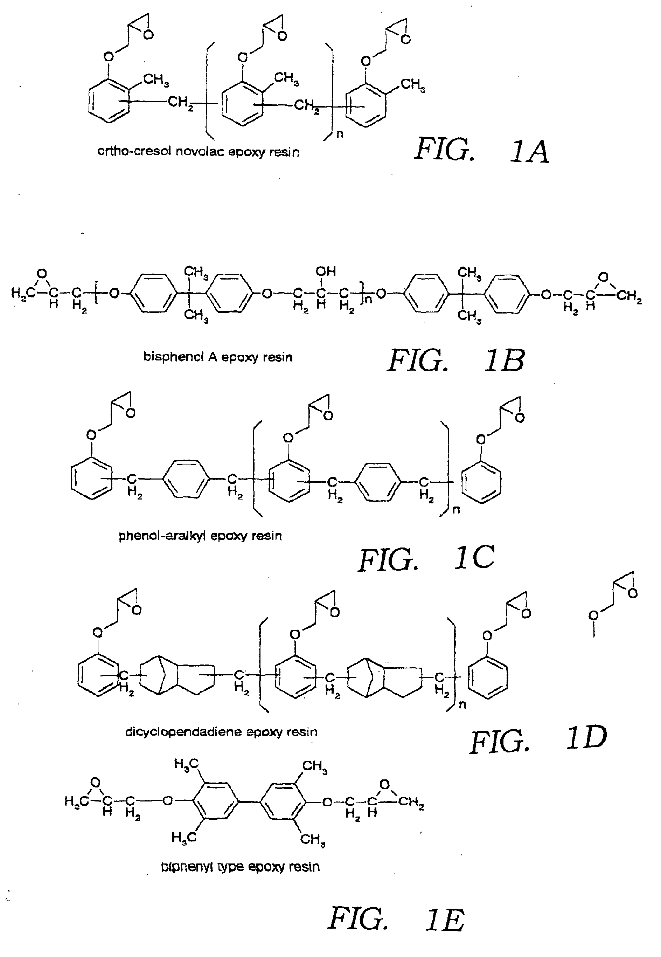

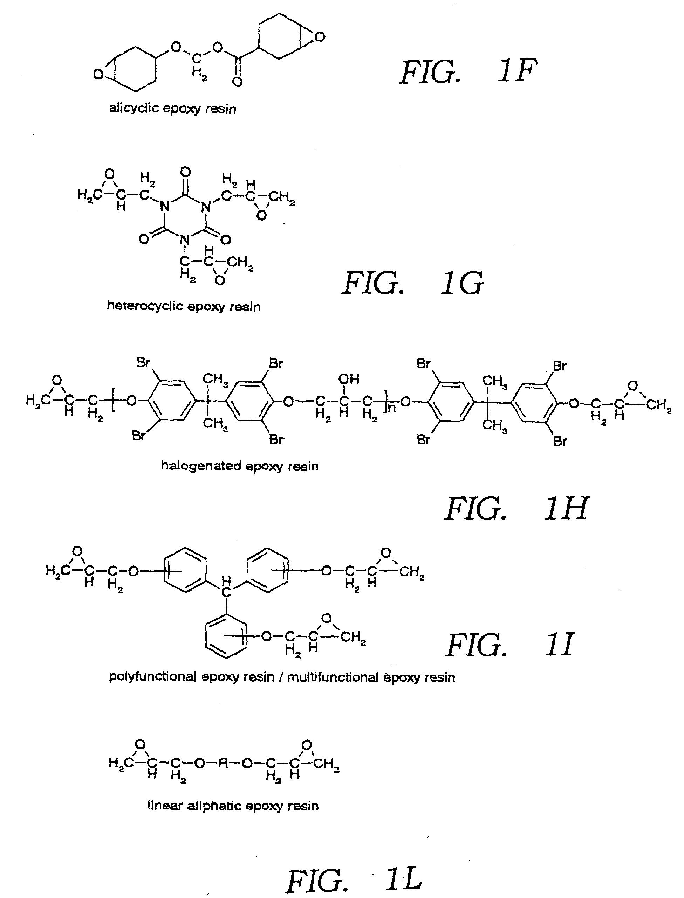

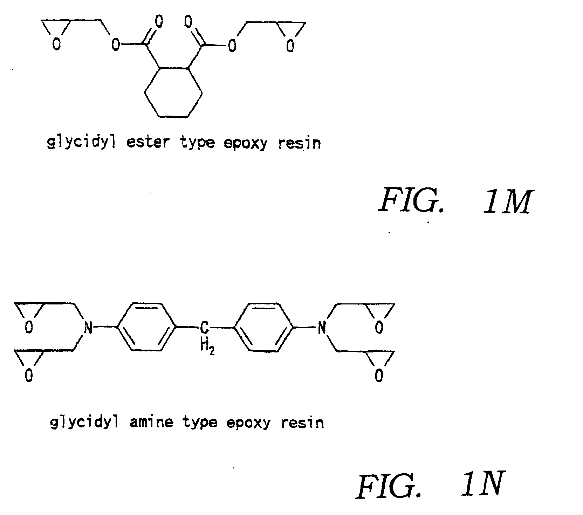

For the purposes of the invention, said at least one epoxy resin is selected from the group comprising: bisphenol A type epoxy resin; phenol-novolac type epoxy resin; creosol-novolac type epoxy resin; glycidyl ester type epoxy resin; biphenyl type epoxy resin; polyfunctional epoxy resin; glycidyl amine type epoxy resin; linear aliphatic epoxy resin; alicyclic epoxy resin; heterocyclic epoxy resin; halogenated epoxy resin, and mixtures thereof. Figures 1A to 1N show the chemical structures of these resins.

Preferably, the epoxy resin used comprises an amount of chlorine ions lower than 10 ppm and an amount of chlorine in hydrolysed form lower than 0.1 % by weight, because such kind of ions cause electronic failures.

For the purposes of the invention, the epoxy resin of preferred use are the glycidyl ester type and the novolac type epoxy resins, the novolac type including 170 to 300 epoxy equivalents. They are suitable for good workability during mold and electronic reliability.

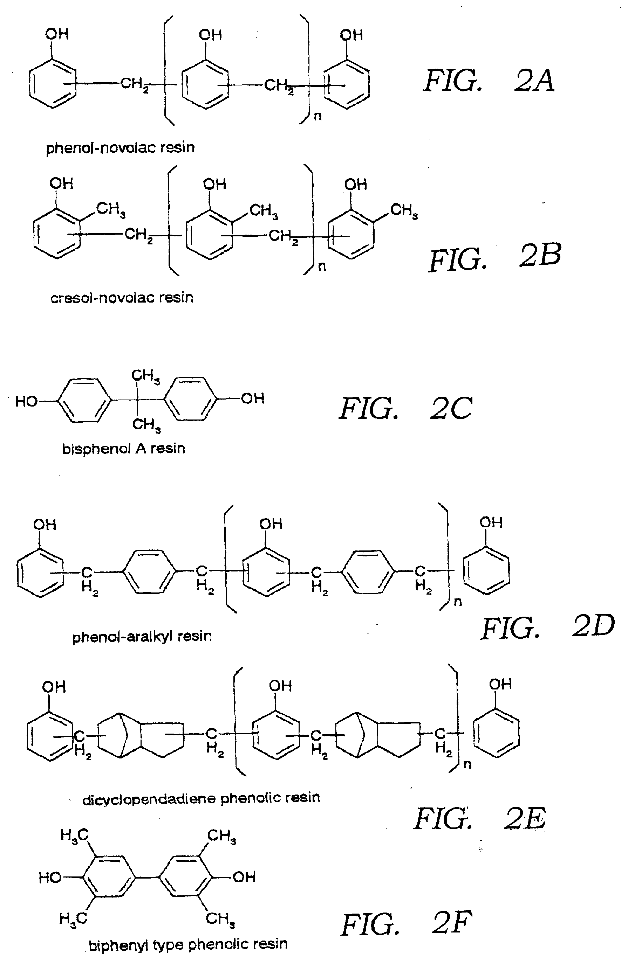

Preferably, said at least one curing agent is a phenolic resin selected from the group comprising: phenol-novolac resin, cresol-novolac resin, bisphenol A resin, phenol-aralkyl resin, dicyclopentane phenolic resin, bisphenyl type phenolic resin, polyfunctional phenolic resin, other denatured phenolic resins, and mixtures thereof. Figures 2A to 2E show the chemical structures of these resins.

Advantageously, the epoxy resin and the phenolic resin are so mixed that the ratio between the number of epoxy equivalents of the epoxy resin and the number of equivalents of the hydroxyl groups of the phenolic resin is comprised between 0.5 and 1.5. It was actually found that if this ratio exceeds the above defined range, a worsening appears in the mechanical strength of the cured epoxy resin.

According to the invention, the aforementioned silica-based reinforcing filler comprises fused silica powder or crystalline silica; said silica powder may generally assume a spherical, lumpy or fibrous shape. Spherical silica is generally used in combination with other fillers which have rougher-diameter.

Such aforementioned silica-based reinforcing filler is incorporated in the polymeric composition in order to adequately protect the semiconductor device and to impart improved workability to the packaging polymeric composition during moulding, thus reducing strain induction in the device itself.

According to a preferred embodiment, the silica-based reinforcing filler includes spherical silica in an amount comprised between 0,05 and 20 % by weight to the total silica-based reinforcing filler.

Advantageously, spherical silica allows to improve the flowability of the polymeric composition. In particular, spherical silica reduces the so-called resin-flush phenomenon, which is characterised by the coming out of a part of the packaging polymeric composition from the air spaces defined between the various sections of the mould.

Preferably, spherical silica has a particle average diameter comprised between 0,3 and 1,5 µm and a surface area comprised between 3 and 10 m²g⁻¹.

In particular, it was found that if the surface area value falls below 2 m²g⁻¹, the so-called resin-flush phenomenon cannot be reduced sufficiently; on the other hand, if the surface area value exceeds 10m²g-¹, an undesired moisture absorption by the polymeric composition may take place.

Preferably, the polymeric composition of the invention further comprises at least one silica coupling agent suitable to react with the surface hydroxyl groups of silica.

Advantageously, the aforesaid coupling agent performs the function of coupling the aforesaid silica-based reinforcing filler to the polymeric matrix, on prior reaction with the epoxy polar groups comprised in the same.

In this way, as said bond takes place in correspondence of polar groups existing *per se* in the polymeric matrix, the number of free epoxy groups reduces, with ensuing further reduction in the polarity of the polymeric composition at the interface with the die of semiconductive material. This results in a further advantageous increase in the reliability of the device.

Preferably, the silica-coupling agent is an amino-silane agent containing secondary amino groups, having the following structural formula:

R-NHR'Si (OR")₃ (I)

Wherein:
R=Ph-, CₙH₂ₙ₊₁, n=1,2,...
R'=-(CH₂)ₘ-,m=1,2,...
R"=CₖH₂ₖ₊₁, k=1,2,...

Advantageously, the secondary amino groups of the amino-silane agent do not significantly increase the polarity of the packaging polymeric composition at the interface with the die of semiconductor material, to the full advantage of the reliability of the device.

For the purposes of the invention, the preferred amino-silane agent is selected from the group comprising: γ-N-methyl amino-propyl triethoxy silane, γ-N-ethyl amino-propyl triethoxy silane, γ-N-phenyl amino-propyl triethoxy silane, γ-N-phenyl amino-propyl trimethoxy silane, N,N-bis[(methyldimethoxysilyl)propyl]amine, N,N-bis[γ-(trimethoxysilyl)propyl]amine, and mixtures thereof.

Preferably, the amino-silane agent is included in an amount comprised between 0,05 and 3 % by weight to the total amount of silica-based reinforcing filler.

In fact, it was observed that when the content of amino-silane coupling agent falls below 0,05 % by weight to the total amount of the silica-based reinforcing filler, silica is not sufficiently coupled to the polymeric matrix and therefore the packaging has a poor homogeneity and is fragile; besides, along with the resin-flush phenomenon also the so-called resin-bleeding may appear, i.e. the coming out of resin and silica-based reinforcing filler from the air spaces of the mould, with an ensuing undesired product loss. In this condition, silica may even show a certain moisture permeability.

Conversely, when the content of amino-silane coupling agent exceeds 3% by weight to the total amount of silica-based reinforcing filler, the part of the same that has not reacted is segregated at the interface and may cause, on the one hand, an increase in polar groups in correspondence of the interface itself, and on the other hand, a dirtying of mould surfaces.

For the purposes of the invention, the control agent for the rheology of the polymeric composition is substantially free from polar groups.

Preferably, the control agent for the rheology of the polymeric composition comprises polydimethylsiloxane substantially free from polyoxyalkylenether groups having the following structural formula:

[Si (CO₃)₂-O]ₙ (II)

which viscosity at 25°C is between 5 and 10⁶ mm²/s.

Advantageously, polydimethylsiloxane allows to effectively act on the rheology of the polymeric composition and can make the workability of the polymeric composition easier.

Preferably, said control agent for the rheology of the polymeric composition is added in an amount comprised between 1 and 5% by weight to the total amount of amino-silane coupling agent.

For the purposes of the invention, the polymeric composition further includes ingredients known *per se,* which are catalysts, such as for instance imidasole and derivatives thereof, derivatives of tertiary amines, phosphines or derivatives thereof; releasing agents, such as for instance natural waxes, synthetic waxes, metal salts of linear aliphatic acids, esters or acid amides and paraffins; flame-retardant agents, such as for instance bromotoluene, hexabromobenzene and antimony oxide, colouring agents such as carbon black; impact modifiers, such as for instance silicone rubber and butadiene rubber; and other common additives.

The polymeric composition of the invention is prepared according to conventional mixing operations, using mixing apparatuses known *per se.* At the end of said conventional mixing operations, the polymeric composition is at first cooled and then ground to powder and lastly pressed into pellets form.

According to a second aspect, the present invention provides a packaging of plastic material for microelectronic applications, that can be obtained by moulding and curing the above described polymeric composition.

The operation of encapsulation of the semiconductor device may be carried out by submitting said polymeric composition to moulding operations conventional *per se,* such as for instance compression moulding, transfer moulding or injection moulding.

Preferably, the moulding operation are performed by means of the most common low-pressure transfer moulding tecnique.

Molding operation is performed by steps: the first consists of the molding compound injection of inside the mold for two minutes during which the great amount of the polymer is cured; the second consists of post mold curing in oven at 150-190°C in N₂, where the molding compound complete the curing process.

According to a third aspect, the present invention provides a semiconductor electronic device of the type comprising at least one semiconductor electronic circuit mounted on a frame and a packaging of plastic material applied on said circuit, characterised in that said packaging can be obtained by moulding and hardening the above described polymeric composition.

The electronic devices according to the invention include, but are not limited to power devices or power packages, integrated circuits (IC), large scale integrated circuits (LSI), bipolar devices and MOS, thrystor devices, diodes and memory devices.

The characteristics and advantages of the invention will be more apparent from the following description of an embodiment solely by way of non limitative indication, with reference to the attached drawings.

### Brief description of the drawings

In the drawings:
- Figures 1A to 1N and 2A to 2E show chemical structures of known resins;
- Figure 3 shows a magnified schematic view in longitudinal section of a semiconductor package according to the invention.

### Detailed description of an embodiment of the invention

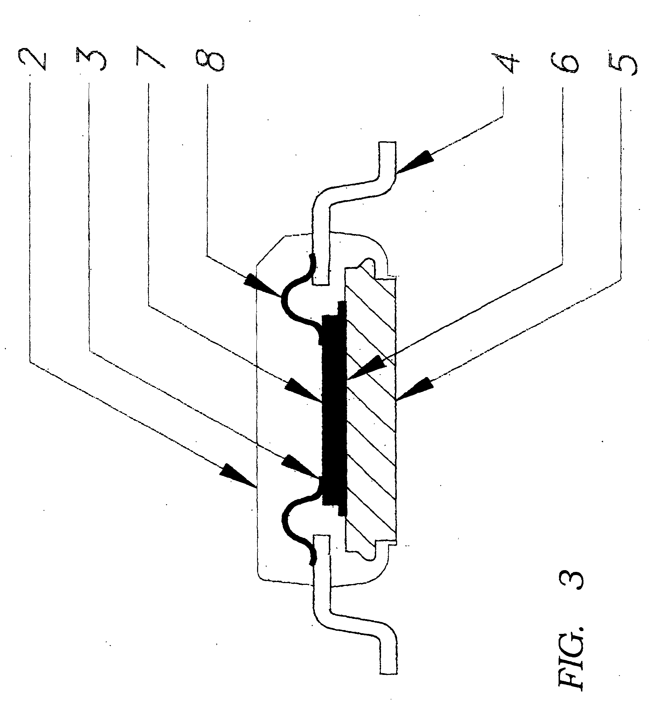

With reference to Figure 3, by 1 there is schematically indicated a power package realised according to the invention.

Package 1 incorporates, in a packaging of plastic material 2, at least one semiconductor integrated electronic circuit mounted on a supporting metal frame 4, as well as a heat dissipating element 5 contacting the circuit. The dissipating element 5 protrudes from the packaging of plastic material 2.

Frame 4 is realised by a thin metal foil.

The circuit is realised on a die 7 of semiconductor material attached on the heat dissipating element 5 by soft solder alloy 6.

Several connectors are formed on frame 4, essentially constituted by contact pins, not shown, which, once the production process has ended, allow to assembly and connect the semiconductor circuit on an electronic pre-printed board.

Peripherally with respect to die 7, prefixed contact points 3 are provided where the terminals of the circuit structure lead to; thin metal wires 8 are connect between said contact points 3 and the internal ends of the corresponding contact pins.

With reference to what hereinabove has been describe, there will be given in the following, by way of non limitative indication, some preferred examples of polymeric compositions according to the invention, particularly suitable for the realisation of the polymer packaging layer on a MOS power package.

### EXAMPLE 1 (Invention)

In a Henschel™ type mixer, fused silica powder, antimony trioxide powder and carbon black powder were added in a first step. Afterwards, a silane coupling agent, an impact modifier, such as a silicon rubber or a butadiene rubber, a control agent for the rheology and the polymeric composition, such as polysiloxane and other additives conventional *per se,* such as natural and synthetic waxes, elastomers, flame-retardants were added to the so obtained polymeric composition.

In a second step, the polymeric composition was intimately mixed at room temperature, so as to disperse silica homogeneously.

Later, the epoxy resin and the phenolic resin were added to the polymeric composition. The so obtained polymeric composition was made homogeneous in a biaxial heating roll, then cooled, ground to powder and pressed into pellets form.

In this way a polymeric composition was obtained having the composition shown in the following Table I.

### EXAMPLES 2-5 (Invention)

In the same way as the preceding Example 1, four more polymeric compositions according to the invention were prepared, whose compositions are shown in the aforesaid Table I.

### EXAMPLES 6-7 (Comparison)

In order to compare the polymeric compositions obtained according to the present invention with those of the known art, two polymeric comparative compositions were prepared in the same way as the preceding Example 1, whose composition is shown in the same Table I.

### EXAMPLE 8 (Workability)

The polymeric compositions of the invention (Examples 1-5) and those of the comparison examples (Examples 6-7) were submitted to a set of tests in order to evaluate the workability characteristics.

In particular, some samples of the polymeric compositions were submitted to a test for the determination of the flowability of the resin during moulding - the so-called "spiral flow" - carried out according to standard norms based on Toshiba Internal Method TM-C7703.

The test provides that a prefixed amount of resin, equal to 20 g, at a temperature comprised between 170 and 175°C be caused to flow through a spiral-shaped duct, under the thrust of an applied pressure of the value of 100 kg/cm²; afterwards, the distance covered (in cm) in 5 ± 2 sec is measured.

Simultaneously, other samples of the aforesaid polymeric compositions were submitted to a test for the determination of the amount of polymeric composition that had come out from mould air spaces - the so-called resin flush - carried out according to standard norms based on Toshiba Internal Method TM-C7706.

The results obtained by the two aforesaid tests are shown in the following Table II.

It must be noted that the optimum range values depend on the type of package, molding machine and so on.

In the light of what has been stressed, the results of Table II show that the polymeric composition of the invention of Example 1 is the one preferred from the workability point of view.

The good workability of the composition of Example 1 lies in the effect of the secondary amino-silane, since it does not include polysiloxane nor spherical silica.

Moreover, the silane of the composition in Example 1 is more effective than the silica of the composition in Example 2: this is the explanation for the worse results in term of resin flush. However, without spherical silica in the composition of the Example 2, the flush should be even worse.

Composition 3 comprises, with respect to composition 1, polysiloxane, which improves workability during pelletizing process. However, as it is known, polydimethylsiloxane has generally worse flowability.

The composition of Example 2 with respect to the composition of Example 5 does not include polyethers, while it includes spherical silica. Due to the effect of aminosilane and polyethers, the resin flush value is under the optimum range: ideally it should be zero.

### EXAMPLE 9 (Reliability of the device)

In order to evaluate the reliability of a semiconductor electronic device, several power devices were realised comprising a semiconductor circuit with the compositions of the invention (Examples 1-5) and the comparison compositions (Examples 6-7). Such devices were submitted to the test indicated by the HTRB initials.

Such test is carried out according to the MIL-STD-750D norms, Method no. 1048. The test provides that the device be reverse biased at 80 % of the breakdown tension, with short-circuited gate and source, at the temperature of 150°C, for a prefixed time. In particular three test times were selected, respectively of 168, 500 and 1000 hours.

The following Table III shows the number of damaged devices to a total of 10 examined devices, relatively to the three aforementioned test times.

The results of Table III clearly show that the compositions of the invention can improve the reliability of the devices compared to the known compositions.

In particular, for the compositions of Examples 1, 3 and 5 no breakdowns were found in the tested devices, even after 1000 test hours.

Additionally, the test was repeated on a second lot of ten devices packaged with the polymer comparative composition of Example 6, but in so doing, the non-reproducibility of the results was obtained. In particular, while in the first case the results shown in Table III were obtained, in the second case, the test brought about the breakdown of all the tested devices for the three test times.

**TABLE I**

| Raw material (% by weight) | Ex1 | Ex2 | Ex3 | Ex4 | Ex5 | Ex6 | Ex7 |
|---|---|---|---|---|---|---|---|
| ortho-cresol novolac type epoxy resin | 12 | 12 | 12 | 8 | 12 | 12 | 8 |
| bromined bisphenol-A type epoxy resin | 3 | 3 | 3 | 2 | 3 | 3 | 2 |
| novolac type phenolic resin | 7 | 7 | 7 | 5 | 7 | 7 | 5 |
| γ-(N-phenylamino) propyl trimethoxy silane | 0.5 | 0.25 | 0.5 | 0.4 | 0.5 | 0 | 0 |
| fine spherical fused silica | 0 | 5 | 0 | 1.5 | 0 | 0 | 0 |
| fused silica | 72 | 67 | 72 | 0 | 72 | 72 | 0 |
| crystalline silica | 0 | 0 | 0 | 80 | 0 | 0 | 81 |
| poly dimethyl siloxane | 0 | 0.25 | 0.25 | 0.4 | 0.25 | 0 | 0 |
| poly dimethyl siloxane with poly oxyalkylated ether group | 0 | 0 | 0 | 0 | 0.001 | 0.3 | 0.4 |
| other additives(including catalyst, waxes, colouring agents) | 5.5 | 5.5 | 5.25 | 2.7 | 5.25 | 5.7 | 3.6 |

**TABLE II**

| Workability | Ex 1 | Ex2 | Ex3 | Ex4 | Ex5 | Ex6 | Ex7 |
|---|---|---|---|---|---|---|---|
| Spiral flow (cm) | 96 | 96 | 69 | 33 | 99 | 102 | 32 |
| Resin flush (mm) (10µm thickness slit) | 1.0 | 2.0 | 2.0 | 1.6 | 0.8 | 2.0 | 4.8 |

**TABLE III**

| Molding compound | Number of failed devices on 10 tested devices at: | | |
|---|---|---|---|
| | 168hours | 500hours | 1000hours |
| Ex.1 | 0 | 0 | 0 |
| Ex.2 | 0 | 1 | 3 |
| Ex.3 | 0 | 0 | 0 |
| Ex.4 | 0 | 3 | 5 |
| Ex.5 | 0 | 0 | 0 |
| Ex.6 | 0 | 2 | 4 |
| Ex.7 | 10 | 10 | 10 |

## Claims

1. A polymeric composition for packaging a semiconductor electronic device comprising:
a) at least one epoxy resin,
b) at least one curing agent, in an amount comprised between 30 and 110 parts by weight per 100 parts by weight of epoxy resin,
c) at least one silica-based reinforcing filler, in an amount comprised between 300 and 2300 parts by weight per 100 parts of epoxy resin,
d) at least one control agent for the rheology of the polymeric composition, substantially free from polar groups, in an amount comprised between 0.1 and 50 parts by weight per 100 parts by weight of epoxy resin.

2. The polymeric composition according to claim 1, **characterised in that** said at least one epoxy resin is selected from the group comprising:
bisphenol A type epoxy resin; phenol-novolac type epoxy resin; cresol-novolac type epoxy resin; glycidyl ester type epoxy resin; biphenyl type epoxy resin; polyfunctional epoxy resin; glycidyl amine type epoxy resin; linear aliphatic epoxy resin; alicyclic epoxy resin; heterocyclic epoxy resin; halogenated epoxy resin, and mixtures thereof.

3. The polymeric composition according to claim 1, **characterised in that** said at least one curing agent is a phenolic resin selected from the group comprising: phenol-novolac resin, cresol-novolac resin, bisphenol A resin, phenol-aralkyl resin, dicyclopentadiene phenolic resin, bisphenyl type phenolic resin, polyfunctional phenolic resin, other denatured phenolic resins, and mixtures thereof.

4. The polymeric composition according to claim 1, **characterised in that** said at least one silica-based reinforcing filler includes spherical silica in an amount comprised between 0,05 and 20 % by weight to the total amount of silica-based reinforcing filler.

5. The polymeric composition according to claim 4, **characterised in that** said spherical silica has an average particle diameter comprised between 0,3 and 1,5 µm, and a surface area comprised between 2 and 10 m²g⁻¹.

6. The polymeric composition according to claim 1, **characterised in that** it further comprises at least one silica-coupling agent suitable to react with said at least one epoxy resin.

7. The polymeric composition according to claim 6, **characterised in that** said at least one silica-coupling agent is an amino-silane agent comprising secondary amino groups, having the following structural formula:
R-NHR'Si (OR")₃ (I)
wherein R, R', R" are:
R=Ph-, CₙH₂ₙ₊₁, n=1,2,...
R'=-(CH₂)ₘ-,m=1,2,...
R"=CₖH₂ₖ₊₁, k=1,2,...

8. The polymeric composition according to claim 7, **characterised in that** said amino-silane agent is selected from the group comprising: γ-N-methyl amino-propyl triethoxy silane, γ-N-ethyl amino-propyl triethoxy silane, γ-N-phenyl amino-propyl triethoxy silane, γ-N-phenyl amino-propyl trimethoxy silane, N,N-bis[(methyldimethoxysilyl)propyl]amine, N,N-bis[γ-(trimethoxysilyl)propyl]amine, and mixtures thereof.

9. The polymeric composition according to claim 7, **characterised in that** said amino-silane agent is added in an amount comprised between 0,05 and 3 % by weight to the total weight of silica-based reinforced filler.

10. The polymeric composition according to claim 1, **characterised in that** said control agent for the rheology of the polymeric composition is substantially free from polyoxyalkylenether groups, and comprises polydimethylsiloxane having the following structural formula:
[Si (CO₃)₂-O]ₙ (II)

11. The polymeric composition according to claim 7, **characterised in that** said at least one control agent for the rheology of the polymeric composition is added in an amount comprised between 1 and 5 % by weight to the amino-silane agent.

12. A packaging of plastic material for microelectronic devices obtainable by moulding and hardening a polymeric composition according to anyone of claims 1-11.

13. A semiconductor electronic device (1) of the type comprising at least one semiconductor electronic circuit mounted on a frame (4) and a packaging (2) of plastic material applied on said circuit, **characterised in that** said packaging (2) can be obtained by moulding and hardening a polymeric composition according to anyone of claims 1-11.
